(19) Europäisches Patentamt
European Patent Office
Office européen des brevets

(11) **EP 2 624 358 A1**

(12) **EUROPEAN PATENT APPLICATION**
published in accordance with Art. 153(4) EPC

(43) Date of publication:
**07.08.2013 Bulletin 2013/32**

(51) Int Cl.:
*H01M 10/48* (2006.01)

(21) Application number: **11829074.1**

(86) International application number:
**PCT/JP2011/071970**

(22) Date of filing: **27.09.2011**

(87) International publication number:
**WO 2012/043521 (05.04.2012 Gazette 2012/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.09.2010 JP 2010214865**

(71) Applicant: **Mitsubishi Heavy Industries, Ltd. Tokyo 108-8215 (JP)**

(72) Inventor: **NISHIDA, Takehiko Tokyo 108-8215 (JP)**

(74) Representative: **HOFFMANN EITLE Patent- und Rechtsanwälte Arabellastrasse 4 81925 München (DE)**

(54) **BATTERY SYSTEM**

(57) A battery system includes secondary batteries (Ca to Ch), temperature sensors (Ta to Th), current sensors (Ia and Ib), voltage sensors (Va to Vh), and a control unit 102. The control unit 102 calculates the charging-discharging power efficiencies of the secondary batteries (Ca to Ch) using the current information and the voltage information, calculates the state of charge of the secondary batteries (Ca to Ch) using the temperature information, the current information, and the voltage information, determines whether the amounts of charge discharged from the secondary batteries (Cato Ch) are substantially equal to the amounts of charge charged in the secondary batteries using the current information, and compares a threshold value set to correspond to the state of charge with the charging-discharging power efficiencies to determine the degradation of the secondary batteries (Ca to Ch) when it is determined that both amounts of charge are equal to each other.

FIG. 1

EP 2 624 358 A1

**Description**

Technical Field

The present invention relates to a battery system, and more particularly, to a battery system that is capable of determining the degradation state of a secondary battery.
Priority is claimed on Japanese Patent Application No. 2010-214865, filed September 27, 2010, the content of which is incorporated herein by reference.

Background Art

The operations of determining the degradation state of a secondary battery such as a lithium ion battery and reflecting the determined degradation state in the management conditions of the secondary battery or displaying the degradation state are useful for a user to safely use the secondary battery or to recognize the time when the secondary battery should be replaced. Accordingly, various techniques of estimating the degradation state of a secondary battery have been reported from this point of view (see PTL 1 to PTL 3).

Citation List

Patent Literature

[PTL 1] Japanese Unexamined Patent Application, First Publication No. 2010-060408
[PTL 2] Japanese Unexamined Patent Application, First Publication No. 2010-093875
[PTL 3] Japanese Unexamined Patent Application, First Publication No. 2004-014403

Summary of Invention

Technical Problem

However, such techniques not only have mechanical and operational problems due to the complex configuration and the complex processing operation needed for determining the degradation of a secondary battery or the like, but also is not satisfactory in view of accuracy.
Therefore, an object of the invention is to provide a battery system that can accurately determine the degradation state of a secondary battery with a simple configuration.

Solution to Problem

According to an aspect of the invention, there is provided a battery system including: a secondary battery; a temperature sensor that measures the temperature of the secondary battery and outputs the measured temperature as temperature information; a current sensor that measures the current of the secondary battery and outputs the measured current as current information; a voltage sensor that measures the voltage of the secondary battery and outputs the measured voltage as voltage information; and a control unit that receives the temperature information, the current information, and the voltage information, wherein the control unit calculates a charging-discharging power efficiency of the secondary battery using the current information and the voltage information, the control unit calculates the state of charge of the secondary battery using the temperature information, the current information, and the voltage information, the control unit estimates whether an amount of electric charge discharged from the secondary battery is substantially equal to an amount of electric charge charged in the secondary battery using the current information, and the control unit determines the degradation of the secondary battery by comparing a threshold value and the charging-discharging power efficiency, the threshold value being set corresponding to the state of charge when the estimation, in which the amount of electric charge discharged from the secondary battery is substantially equal to the amount of electric charge charged in the secondary battery, is obtained.
Accordingly, when the amount of electric charge discharged from a secondary battery is substantially equal to the amount of electric charge charged in the secondary battery, the degradation determination is performed using the charging-discharging power efficiency. As a result, it is possible to accurately determine the degradation of the secondary battery and to perform the degradation determination with a simple configuration of comparing the charging-discharging power efficiency with a threshold value.

Advantageous Effects of Invention

In the battery system according to the invention, it is possible to accurately determine the degradation states of secondary batteries with a simple configuration.

Brief Description of Drawings

FIG. 1 is a diagram schematically illustrating the configuration of a battery system according to a first embodiment of the invention.

FIG. 2 is a diagram partially illustrating the configuration of a BMS in the battery system according to the first embodiment of the invention.

FIG. 3 is a diagram illustrating an example of a measured current used to illustrate the determination of degradation of a secondary battery in the battery system according to the first embodiment of the invention.

FIG. 4 is a diagram illustrating secondary batteries used in the battery system according to the first embodiment of the invention.

FIG. 5 is a detailed diagram illustrating an SOC calculating unit 1 in the battery system according to the first embodiment of the invention.

FIG. 6 is a first diagram illustrating the output value of the SOC calculating unit 1 in the battery system according to the first embodiment of the invention.

FIG. 7 is a second diagram illustrating the output value of the SOC calculating unit 1 in the battery system according to the first embodiment of the invention.

FIG. 8 is a diagram partially illustrating the configuration of a BMS in a battery system according to a second embodiment of the invention.

FIG. 9 is a diagram illustrating charging and discharging characteristics of a secondary battery.

Description of Embodiments

A battery system according to a first embodiment of the invention determines the degradation state of a secondary battery on the basis of a variation in charging-discharging the power efficiency of the secondary battery. Hereinafter, the battery system will be described in detail with reference to the accompanying drawings.

First Embodiment

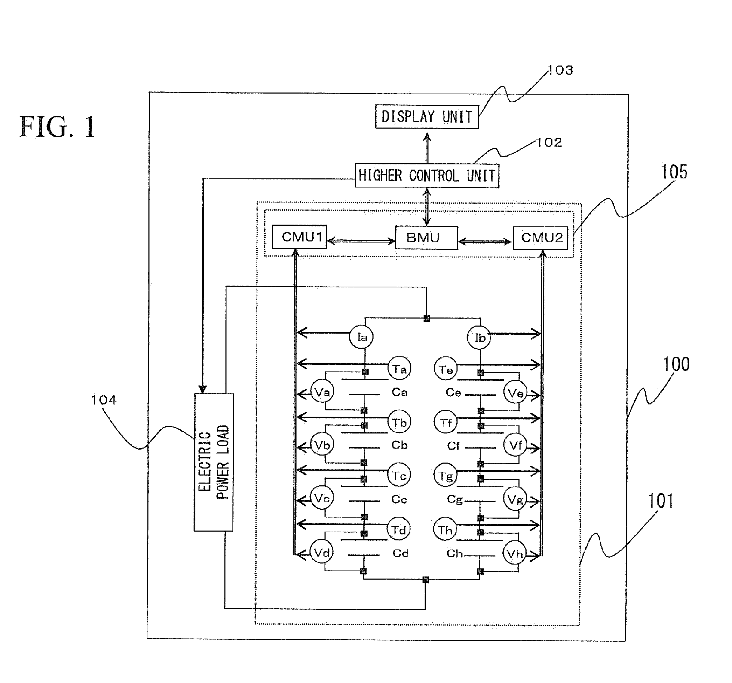

Hereinafter, the battery system according to the first embodiment of the invention will be described with reference to the accompanying drawings. FIG. 1 is a diagram illustrating the configuration of the battery system 100 according to the first embodiment of the invention.

The battery system 100 includes a battery module 101, a higher control unit 102, a display unit 103, an electric load 104, and a BMS (Battery Management System) 105.

The battery module 101 including a battery system having secondary batteries Ca to Ch and the BMS 105 which is a monitoring and control unit of the battery system is inserted and fixed into the battery system 100 from the outside of the battery system 100. By employing this module, the battery module can be easily replaced from the outside of the battery system 100. The electric load 104, the higher control unit 102, and the display unit 103 are mounted in advance on the battery system 100. The higher control unit 102 and the BMS 105 are also collectively simply referred to as a control unit.

Here, examples of the battery system 100 according to the invention include industrial vehicles such as forklifts in which vehicle wheels are connected to an electric motor as the electric load 104, moving objects such as electric trains or electric vehicles, and moving objects such as airplanes or ships in which a propeller or a screw is connected to an electric motor as the electric load 104. Examples of the battery system 100 further include a household power storage system and a power storage system for grid stabilization combined with natural energy generation such as wind turbine generator or solar cell. That is, the battery system 100 is a system using the charging and discharging of power in secondary batteries constituting a battery system.

The battery system in the battery module 101 supplies power to the electric load 104 of the battery system 100. An arm including the secondary batteries Ca to Cd connected in series and an arm including the secondary batteries Ce to Ch connected in series are connected in parallel. A corresponding pair of temperature sensors Ta to Th and voltage sensors Va to Vh is provided to each of the secondary batteries Ca to Ch constituting the battery system. Temperature of the secondary batteries are measured by the temperature sensors Ta to Th. Cell voltage of the secondary

batteries are measured by the voltage sensors Va to Vh. Current sensors Ia and Ib are disposed to each of the arms. Current flowing in each arm can be measured by the Current sensors Ia and Ib. Measurement information measured and output by these sensors is input to the BMS 105 to be described later in detail.

Here, four secondary batteries are connected in series to form an arm and two arms in total are connected in parallel. However, the number of secondary batteries connected to each arm and the number of arms may be designed to be one or two or more.

The higher control unit 102 controls the electric load 104 in accordance with a user's instruction (for example, the amount by which the user steps on an accelerator pedal), receives information (including information relevant to the measurement information and the state of charge (SOC) of the secondary batteries calculated by the BMS 105) relevant to the battery system and transmitted from the BMS 105, and controls the display unit 103 so as to appropriately display the relevant information on the display unit 103. When determining that the relevant information is abnormal, the higher control unit 102 lights an abnormal lamp built in the display unit 103, operates an acoustic device such as a buzzer built in the display unit 103 to give an alarm, and stimulates a visual sense and an auditory sense by the use of light and sound to attract the user's attention.

The display unit 103 is a monitor such as a liquid crystal panel including the acoustic device and can display the relevant information of the secondary batteries Ca to Ch constituting the battery system under the control of the higher control unit 102.

The electric load 104 is a power converter such as an electric motor or an inverter connected to wheels of an electric vehicle. The electric load 104 may be an electric motor driving a windshield wiper or the like.

The BMS 105 will be described below in brief and then the operation or the like thereof will be described in detail. As shown in FIG. 1, the BMS 105 of the battery system 100 includes two CMUs (Cell Monitor Unit), that is, CMU1 and CMU2, and a BMU (Battery Management Unit).

Here, CMU1 and CMU2 include an ABC (Analog Digital Converter), not shown, receive the measurement information sensed and output by various sensors as analog signals, convert the analog signals into corresponding digital signals through the use of the ADC, and output the digital signals to the BMU as parameters used to calculate the relevant information. In this embodiment, as shown in FIG. 1, each CMU is connected to four secondary batteries through a bus or a signal line.

The BMU performs a degradation determining process on each secondary battery to be described later on the basis of the parameters of the secondary batteries Ca to Ch input from two CMU, and outputs the determination result to the higher control unit 102. Here, among the values of the plural parameters converted into the digital signals, the digital signals into which the analog signals measured by the temperature sensors Ta to Th are converted are referred to as the measured temperatures of the corresponding secondary batteries, the digital signals into which the analog signals measured by the voltage sensors Va to Vh are converted are referred to as the measured voltages of the corresponding secondary batteries, and the digital signals into which the analog signals measured by the current sensors Ia to Ib are converted are referred to as the measured currents of the corresponding secondary batteries,

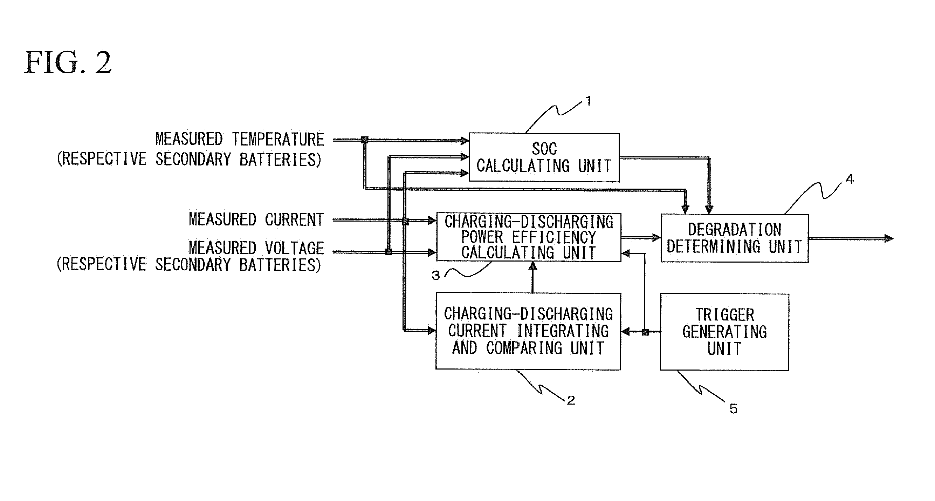

The configuration and operation of the BUMS 105 used to determine the degradation of each secondary battery will be described below in detail. FIG. 2 shows the configuration in the BMS 105 used to determine the degradation. Here, the configuration shown in FIG. 2 exists in the BMU. For the purpose of facilitating understanding, one arm, for example, the arm in which the secondary batteries Ca to Cd are connected in series, will be mainly described. Since the following description is applicable to the other arm, the other arm will not be described. The degradation determination to be described below may be simultaneously performed on all the arms or may be performed on the arms with a time difference for each arm so as to reduce the burden on the control unit.

The BMU includes an SOC calculating unit 1, a charging-discharging current integrating and comparing unit 2, a charging-discharging power efficiency calculating unit 3, a degradation determining unit 4, and a trigger generating unit 5 in order to determine the degradation ofthe respective secondary batteries Ca to Cd.

The trigger generating unit 5 outputs a trigger signal for each predetermined period (for example, every hour) for determining the degradation of each secondary battery. By causing a user of the battery system 100 to control the higher control unit 102, the higher control unit 102 may control the trigger generating unit 5 so as to output a trigger signal at an arbitrary time, not limited to the predetermined period.

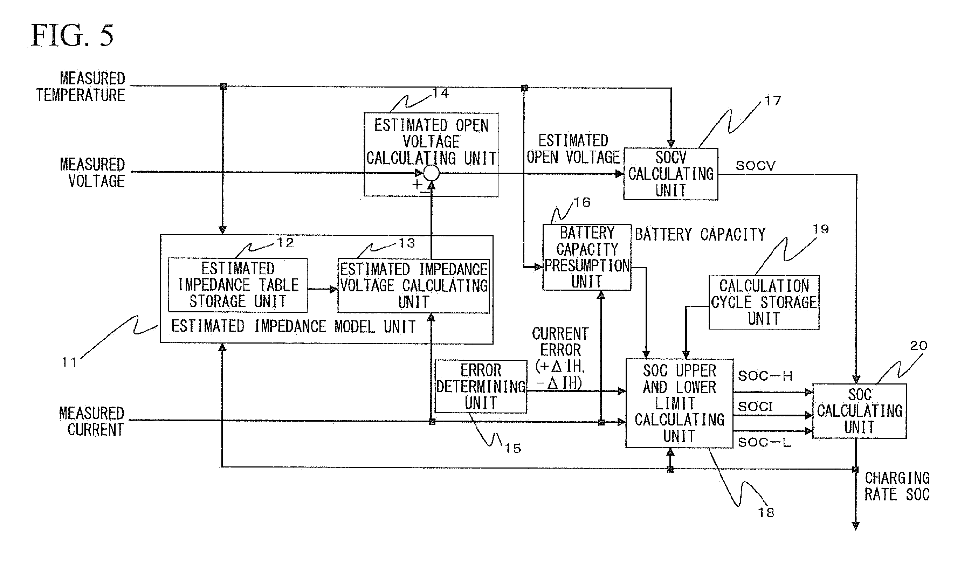

The SOC calculating unit 1 receives the measured temperatures of the secondary batteries Ca to Cd, the measured current of the corresponding arm, and the measured voltages of the secondary batteries from the CMU1, calculates the charging rate SOC (%) of each of the secondary batteries Ca to Cd for every predetermined period (for example, 1 minute), and outputs the state of charge of the secondary batteries. In order to accurately calculate the state of charge, the SOC calculating unit 1 has the configuration shown in FIG. 5, which will be described later.

Here, the state of charge is output for every predetermined period, but the charging-discharging current integrating and comparing unit 2 and the charging-discharging power efficiency calculating unit 3 start their calculations and the like in synchronization with the trigger signal output from the trigger generating unit 5 as described later. Accordingly, in order to output more accurate values of the present state of charge SOC (%), the state of charge may be calculated and output in synchronization with the trigger signal input to the SOC calculating unit 1.

The charging-discharging current integrating and comparing unit 2 receives the measured current corresponding to the current measured by the current sensor (here, the current sensor Iz), divides the measured current into two types of the charging current and the discharging current in response to the trigger signal output from the trigger generating unit 5, individually integrates the currents, and compares the integrated value of the charging current with the integrated value of the discharging current to determine whether both integrated values are equal (or substantially equal) to each other. When it is determined that both integrated values are equal (or substantially equal) to each other, a matching signal is output to the charging-discharging power efficiency calculating unit 3.

For example, it is assumed that the battery system 100 is an electric vehicle. Then, a mechanism may be constructed so that the discharging is carried out when a user steps on an accelerator pedal for acceleration and the regenerative charging is carried out when the user detaches the foot from the accelerator pedal. Here, since the adjustment of stepping on the accelerator pedal or the like is frequently carried out, the integrated value of the charging current (charging current integrated value) and the integrated value of the discharging current (discharging current integrated value) can be made to be equal to each other for a short time.

Since the integration is started after the trigger signal is input, it is preferable to make the comparison using the integrated value (referred to as the integrated value of a single peak) as a reference value. The integration is performed from the time point when the measured current value became 0 A to the next time point when the measured current value became 0 A again after transition of the current value in a positive direction (charging, for example) or a negative direction (discharging, for example) in the direction of time passage.

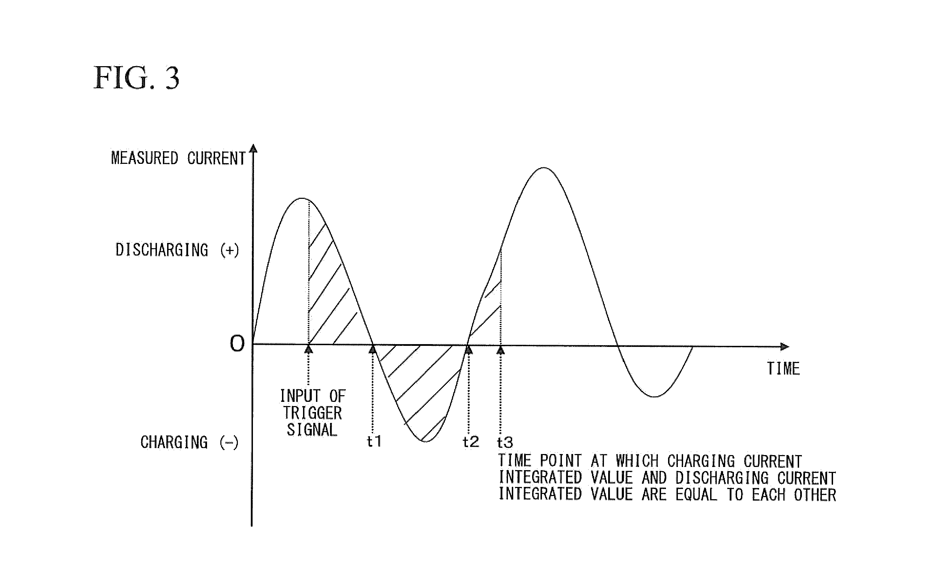

Specifically, when the measured current value is changed as shown in FIG. 3, the trigger signal is input at the time of discharge and thus the integration of the discharging current is started therefrom. The measured current value is changed from the discharging to the charging at the time point of time t1. That is, the measured current value once becomes 0 A. The charging is performed until the time point of time t2 and then the discharging is performed again. At the time point of time t2, the current value becomes 0 A again. Since the charging is performed from time t1 to time t2, the charging current is integrated in the meantime, but the charging current integrated value from time t1 to time t2 is the integrated value of a single peak and is used as the reference value for comparison. Accordingly, when the sum of the discharging current integrated value from the time point of inputting the trigger signal to time t1 and the integrated value of the discharging current from time t2 to time t3 (the time point at which the integrated value of the discharging current and the integrated value of the charging current from the time point of inputting the trigger signal are equal to each other) is equal to the reference value, the charging-discharging current integrating and comparing unit 2 outputs the matching signal.

The charging peak from time t1 to time t2 in FIG. 3 is a peak having one peak, but the number of peaks may be two or more. In this case, in the progressing direction of time, the integrated value from the time point at which the measured current value becomes 0 A to the time point at which the measured current value is changed in the positive direction (discharging) or in the negative direction (charging) and becomes 0 A again is defined as the integrated value of a peak. Here, the integrated value of a peak is used as the reference value for comparison, but the integrated value obtained by combining peaks (for example, two peaks) in the same direction used as the reference may be used as the reference value.

The current flowing via the current sensor may be calculated as minus (negative) in the case of charging and plus (positive) in the case of discharging as shown in FIG. 3, and thus the absolute values of the charging current integrated value and the discharging current integrated value have only to be compared with each other. This is because it is surely possible to avoid erroneous comparison.

The charging-discharging power efficiency calculating unit 3 receives the measured current and the measured voltages of the secondary batteries and outputs the charging-discharging power efficiency E when the matching signal is input from the charging-discharging current integrating and comparing unit 2.

Here, the charging-discharging power efficiency E is expressed by $E=\{\int(I_{dis}\times V_{dis})dt\}/\{\int(I_{cha}\times V_{cha})dt\}$, where $I_{dis}$ represents the discharging current of a secondary battery, $V_{dis}$ represents the voltage (voltage across the electrodes) across a positive electrode and a negative electrode at the time of discharging the secondary battery, $I_{cha}$ represents the charging current of the secondary battery, and $V_{cha}$ represents the voltage across the electrodes at the time of charging the secondary battery. The calculation of $\int(I_{dis}\times V_{dis})dt$ and $\int(I_{cha}\times V_{cha})dt$ is started when the trigger signal from the trigger generating unit 5 is input to the charging-discharging power efficiency calculating unit 3. When the matching signal is input from the charging-discharging current integrating and comparing unit 2, the charging-discharging power efficiency E is calculated and output.

The degradation determining unit 4 performs the degradation determining process on the secondary battery using the input measured temperature and the charging rate SOC input from the SOC calculating unit 1 when the charging-discharging power efficiency E is input from the charging-discharging power efficiency calculating unit 3, outputs a degradation signal to the higher control unit 102 when it is determined that the degradation progresses and the secondary battery is abnormal, and outputs a normal signal to the higher control unit 102 when it is determined that the degradation is allowable and the secondary battery is normal. This process will be described below in detail.

The degradation determining unit 4 includes data tables in which the values of the charging-discharging power efficiency (allowable charging-discharging power efficiency) allowed for the battery system 100 are recorded to correspond to the measured temperatures T(°C) and the state of charge SOC (%) of the secondary batteries therein (for example, the data tables are constructed by nonvolatile memories). Specifically, a data table is provided for every predetermined temperature (every 1 °C such as 20°C, 21°C, and 22°C) and the values of the allowable charging-discharging power efficiency (for example, 70% for the charging rate 20%, 75% for the charging rate 30%, and 80% for the charging rate 40%) every predetermined charging rate (every 5% such as 40%, 45%, and 50%) are recorded on each data table.

When the measured temperature T (°C) is different from the temperatures prepared in the data tables, that is, when the temperature nearest to the measured temperature T (°C) in the data tables are T1 and T2 (T1 (°C)< T (°C)< T2 (°C)), the degradation determining unit 4 selects the data table prepared for T2 (°C) if $(\Delta T/2)\leq\Delta T1$ is established where T2-T1=$\Delta T$ and T-T1=$\Delta T1$, and selects the data table prepared for T1 if $\Delta T1<(\Delta T/2)$ is established. For example, when the measured temperature is 20.4° and two data tables of 20°C and 21°C nearest to the measured temperature are prepared, the data table of 20°C is selected. This is because it is possible to more accurately determine the degradation by using the data table closer to the measured temperature T (°C).

Here, when the period of time from the time point at which the trigger signal is input to the time point at which the integrated value of the discharging current and the integrated value of the charging current are equal to each other is short, the temperature variation of the secondary battery in the meantime can be considered to substantially be zero. Accordingly, only when the measured temperature is a predetermined temperature (for example, a predetermined temperature which is estimated as the average temperature of the secondary batteries when the battery system works), may the degradation determining unit 4 be configured to perform the degradation determination process. In this case, the number of data tables having recorded thereon the values of allowable charging-discharging power efficiency to correspond to the state of charge SOC (%) of the secondary batteries need not be two or more for each measured temperature, but may be only one. At this time, the input of the measured temperature to the degradation determining unit 4 is not necessary and the trigger generating unit 5 has only to detect the predetermined temperature and generate the trigger signal.

The degradation determining unit 4 selects the data table corresponding to the measured temperature T (°C) as described above, and then selects the allowable charging-discharging power efficiency corresponding to the input charging rate SOC (%). At this time, when the charging rate SOC (%) is different from the value of a predetermined charging rate prepared in the data table, that is, when the state of charge nearest to the input charging rate SOC (%) among the state of charge prepared in the selected data table are SOC1 and SOC2 (SOC1 (%)<SOC (%)<SOC2 (%)), the degradation determining unit 4 selects the allowable charging-discharging power efficiency corresponding to SOC2 (%) if $(\Delta SOC/2)\leq\Delta SOC1$ is established where SOC2-SOC1=$\Delta SOC$ and SOC-SOC1=$\Delta SOC1$, and selects the allowable charging-discharging power efficiency corresponding to SOC1 (%) if $\Delta SOC1<(\Delta SOC/2)$ is established. For example, when the charging rate SOC (%) input from the SOC calculating unit 1 at a certain measured temperature is 43% and two state of charge of 40% and 45% nearest to the charging rate SOC (%) are prepared in the data table corresponding to the measured temperature, the allowable charging-discharging power efficiency corresponding to the charging rate of 45% is selected. This is because it is possible to more accurately determine the degradation by using the charging-discharging power efficiency corresponding to the charging rate closer to the charging rate SOC (%).

Therefore, the degradation determining unit 4 selects the data of the charging rate nearest to the charging rate SOC input from the SOC calculating unit 1 from the data table nearest to the input measured temperature and selects the allowable charging-discharging power efficiency corresponding to the selected charging rate SOC from the data table. The degradation determining unit 4 compares the selected allowable charging-discharging power efficiency with the charging-discharging power efficiency E input from the charging-discharging power efficiency calculating unit 3, determines that the secondary battery is abnormal when the "selected allowable charging-discharging power efficiency">the "input charging-discharging power efficiency E" is established, and outputs the degradation signal.

When the "selected allowable charging-discharging power efficiency"<the "input charging-discharging power efficiency E", the degradation determining unit determines that the secondary battery is normal and outputs a normal signal.

Here, when the measured temperature T (°C) and the charging rate SOC (%) input to the degradation determining unit 4 are equal to the corresponding values prepared in the data table, the values of the corresponding allowable charging-discharging power efficiency recorded in the data table can be set as the "selected allowable charging-discharging power efficiency".

As described above, when the values corresponding to the measured temperature T (°C) and the charging rate SOC (%) input to the degradation determining unit 4 are not prepared in the data table, the corresponding nearest values among the prepared values are considered as the values of the measured temperature T (°C) and the charging rate SOC and the allowable charging-discharging power efficiency corresponding thereto is selected.

However, in order to more accurately perform the degradation determination, the allowable charging-discharging power efficiency may be calculated as follows. That is, the allowable charging-discharging power efficiency corresponding to the value of the charging rate SOC may be calculated (the calculated allowable charging-discharging power efficiency is defined as Ep) using the linear ratio of P with respect to the nearest value (referred to as "nearest value 1") smaller than the value of the charging rate SOC input to the degradation determining unit 4 among the prepared values and the nearest value (referred to as "nearest value 2") larger than the value of the charging rate SOC.

In this case, when the allowable charging-discharging power efficiency corresponding to nearest value 1 prepared in the data table is defined as P1 and the allowable charging-discharging power efficiency corresponding to nearest value 2 is defined as P2, Ep=P1+{(P2-P1)×{(P-nearest value 1)/(nearest value 2-nearest value 1)}} is established.

The mechanism allowing the degradation determination of the secondary batteries Ca to Ch mounted on the battery system 100 is as follows.

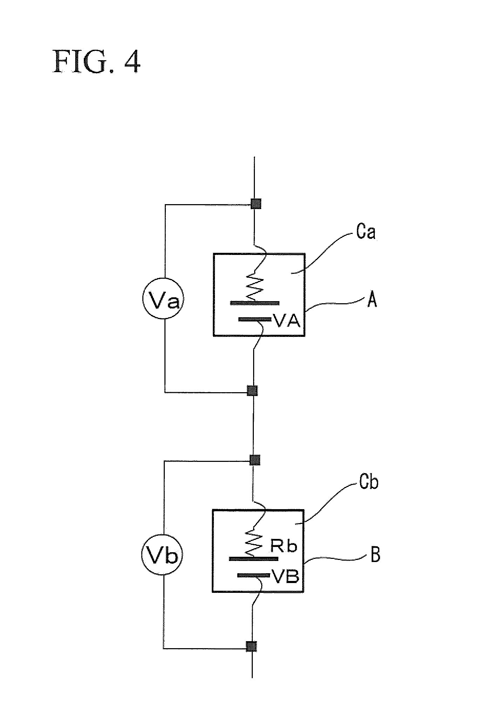

For the purpose of convenient explanation, a partially detailed diagram of the secondary batteries in FIG. 1 is shown in FIG. 4. Here, the secondary battery Ca and the secondary battery Cb are shown and each secondary battery has a battery vessel as a constituent element. The positive electrodes and the negative electrodes drawn out from the battery vessel are connected in series.

In each battery vessel, a positive electrode material, a negative electrode material, and an electrolyte are enclosed therein, the positive electrode material is electrically connected to the positive electrode, and the negative electrode material is electrically connected to the negative electrode, whereby the function of a secondary battery is performed. The voltage across the positive electrode and the negative electrode of a single secondary battery is a voltage across the electrodes of the secondary battery, but when the secondary battery degrades, the value of internal resistance increases and a power difference is caused between the charging and the discharging (in FIG. 4, the value of the internal resistance of the secondary battery Ca is expressed as Ra, the value of the internal voltage of the battery vessel A is expressed as VA, the value of the internal resistance of the secondary battery Cb is expressed as Rb, and the value of the internal voltage of the battery vessel B is expressed as VB).

For example, paying attention to the secondary battery Ca, as described above, $V_{cha}=VA+(Ra \times I_{cha})$ and $V_{dis}=VA-(Ra \times I_{dis})$ are established, where $V_{dis}$ represents the voltage across the electrodes at the time of discharging measured by the voltage sensor Va, $V_{cha}$ represents the voltage across the electrodes at the time of charging measured by the voltage sensor Va, $I_{dis}$ represents the discharging current of the secondary battery Ca, and $I_{cha}$ represents the charging current of the secondary battery Ca. Accordingly, the charging-discharging power efficiency e at a certain time point of the secondary battery Ca is smaller than 1 due to the originally-present internal resistance and $e=(I_{dis} \times V_{dis})/(I_{cha} \times V_{cha})<1$ is established.

However, a secondary battery cannot simultaneously perform the charging and the discharging in view of a mechanism. Accordingly, when the internal voltage at a certain time point at which the discharging is performed is defined as Va1 and the internal voltage at a time point at which the charging is performed with a predetermined time therebetween is defined as Va2, Va1≠Va2 is generally established. Since the predetermined time is set to such a time in which the internal resistance does not vary, the internal resistance Ra is substantially a fixed value.

The charging-discharging power efficiency e is calculated with Va1=Va2 and can be used as an index value indicating the degree of influence which the internal resistance gives to the charging and discharging. Accordingly, it is necessary to substantially satisfy Va1=Va2. Here, when Va1=Va2 is satisfied, it is considered that the same amount of electric charge is accumulated in the secondary battery. Therefore, at the time point at which the discharged amount of electric charge and the charged amount of electric charge are substantially equal to each other, the battery system 100 according to this embodiment performs the degradation determination. Particularly, in a secondary battery such as a lithium ion battery in which the efficiency based on an integrated current value (coulombic efficiency) of the charging and discharging is almost 100%, Va1 may be set equal to Va2.

Specifically, the degradation of the respective secondary batteries is determined at the time point at which the charging current integrated value and the discharging current integrated value are substantially equal to each other. Accordingly, the charging-discharging power efficiency is not expressed as a value at a certain time point, but is expressed as an integrated value with a predetermined time width, that is, $E=\{\int(I_{dis} \times V_{dis})dt\}/\{\int(I_{cha} \times V_{cha})dt\}$. Accordingly, the values of the charging-discharging power efficiency E of each secondary battery at the time point at which the charging current integrated value and the discharging current integrated value are substantially equal to each other is a value of an index (index value) indicating the degree of degradation of the corresponding secondary battery.

The index value can be acquired through the above-mentioned calculation. However, in order to perform the degradation determination of a secondary battery, a reference value used to determine the degradation of the secondary battery corresponding to an index value of the secondary battery is necessary. Accordingly, the allowable charging-discharging power efficiency is used as the reference value (or threshold value).

Paying attention to any one secondary battery, when the value of the secondary battery is the same but the charging rate (SOC) of the secondary battery varies, it is experimentally proved that the degree of influence of the interval resistance on the charging and discharging operation varies. Accordingly, the values of allowable charging-discharging power efficiency corresponding to each measured temperature and each state of charge are recorded and set in advance in the data tables (for example, nonvolatile memories) before the shipment from a factory. Here, if the state of charge differs at the same temperature, it means that the amount of electric charge accumulated in the secondary battery varies. That is, if the amount of electric charge accumulated in the secondary battery differs, it means that the degree of influence of the internal resistance on the charging and discharging operation varies.

Therefore, it can be said that the degradation determination of each secondary battery in the battery system 100 according to this embodiment is made by comparing the threshold value and the charging-discharging power efficiency. The threshold value and the charging-discharging power efficiency are set for each of the present amount of electric charge stored in the secondary batteries (that is state of charge) at the time point when the charged amount and the discharged amount are equal to each other.

By using the calculation expression of the charging-discharging power efficiency E, it is determined that the secondary battery degrades when the charging-discharging power efficiency E is smaller than the threshold value. A value calculated using an expression in which the denominator and the numerator in the calculation expression of the charging-discharging power efficiency E is inverted may be called the charging-discharging power efficiency. In this case, the threshold value for each state of charge can be appropriately set to the values different from those in the above-mentioned calculation expression of the charging-discharging power efficiency E and it may be determined that the secondary battery degrades when the charging-discharging power efficiency is larger than the threshold value.

In the battery system 100 according to this embodiment, How accurately to calculate the present charging rate SOC of each secondary battery is important in accurately performing the degradation determination of the corresponding secondary battery. Accordingly, for example, the SOC calculating unit 1 shown in FIG. 2 is constructed as shown in FIG. 5. In the configuration shown in FIG. 5, since the reliability of the estimated state of charge based on a voltage is generally higher than that of the estimated state of charge based on a current, the estimated state of charge based on the voltage is basically used as the present estimated state of charge, which is more accurately calculated. The SOC calculating unit 1 will be described below.

The configuration of the SOC calculating unit 1 is shown in FIG. 5. The SOC calculating unit 1 includes an estimated impedance model unit 11 (including an estimated impedance table storage unit 12 and an estimated impedance voltage calculating unit 13), an estimated open voltage calculating unit 14, an error determining unit 15, a battery capacity presumption unit 16, an SOCV calculating unit 17, an SOC upper and lower limit calculating unit 18, a calculation cycle storage unit 19, and an SOC calculating unit 20.

The measured temperatures and the measured voltages to be described later are information corresponding to the measurement information from the secondary batteries Ca to Ch, the measured current to be described later is information corresponding to the measurement information from the arms, these pieces of information are input to the SOC calculating unit 1 to calculate the charging rate of each secondary battery, as shown in FIG. 2. However, for the purpose of convenient explanation, attention will be paid to one secondary battery among the secondary batteries below.

The estimated impedance model unit 11 includes the estimated impedance table storage unit 12 and the estimated impedance voltage calculating unit 13. The estimated impedance table storage unit 12 includes data tables (for example, formed of a nonvolatile memory) on which the measured temperatures T (°C) corresponding to the temperature of the battery vessel of the secondary battery and estimated impedance Z ($\Omega$) in the secondary battery corresponding to the charging rate SOC (%) of the secondary battery are recorded. Specifically, a data table is provided for every predetermined temperature (every 1°C such as 20°C, 21°C, and 22°C) and the values ofthe estimated impedance for every predetermined state of charge (every 5% such as 40%, 45%, and 50%) are recorded on each data table.

The estimated impedance table storage unit 12 receives the measured temperature T (°C) corresponding to the temperature output from the temperature sensor connected to the secondary battery and the charging rate SOC (%) output from the SOC calculating unit 20 to be described later and outputs the estimated impedance Z (Q) corresponding to the measured temperature T (°C) and the charging rate SOC (%) to the estimated impedance table storage unit 12 using the data tables.

When the measured temperature T (°C) is different from the temperatures prepared in the data tables, that is, when the temperature nearest to the measured temperature T (°C) in the data tables are T1 and T2 (T1 (°C)< T (°C)< T2 (°C)), the estimated impedance table storage unit 12 selects the data table prepared for T2 (°C) if $(\Delta T/2)<\Delta T1$ is established where T2-T1 $=\Delta T$ and T-T1$=\Delta T1$, and selects the data table prepared for T1 if $\Delta T1<(\Delta T/2)$ is established. For example, when the measured temperature is 22.4° and two data tables of 22°C and 23°C nearest the measured temperature are prepared, the data table of 22°C is selected. This is because it is possible to calculate the state of charge with a smaller error by using the data table closer to the measured temperature T (°C).

The estimated impedance table storage unit 12 selects the data table corresponding to the measured temperature T (°C) as described above, and then selects the estimated impedance Z (Q) corresponding to the charging rate SOC (%) input from the SOC calculating unit 20. At this time, when the charging rate SOC (%) is different from the value of a predetermined charging rate prepared in the data table, that is, when the state of charge nearest to the input charging rate SOC (%) among the state of charge prepared in the selected data table are SOC1 and SOC2 (SOC1 (%)<SOC (%)<SOC2 (%)), the estimated impedance table storage unit 12 selects the estimated impedance corresponding to SOC2 (%) if $(\Delta SOC/2)\leq\Delta SOC1$ is established where SOC2-SOC1$=\Delta SOC$ and SOC-SOC1$=\Delta SOC1$, and selects the

estimated impedance corresponding to SOC1 if ΔSOC1<(ΔSOC/2) is established. For example, when the charging rate SOC (%) input from the SOC calculating unit 20 at a certain measured temperature is 48% and two state of charge of 45% and 50% nearest to the charging rate SOC (%) are prepared in the data table corresponding to the measured temperature, the estimated impedance corresponding to the state of charge of 50% is selected and is output as the estimated impedance Z (Ω). This is because it is possible to calculate the state of charge with a smaller error by using the estimated impedance corresponding to the state of charge closer to the charging rate SOC (%).

The estimated impedance voltage calculating unit 13 is a processing unit that receives the measured current I (A) corresponding to the current output from the current sensor connected to the secondary battery of which the state of charge should be calculated and the estimated impedance Z (Ω), that calculates an estimated impedance voltage VZ (V), and that outputs the calculated voltage to the estimated open voltage calculating unit 14 to be described later. Specifically, the calculation of measured current I (A)×estimated impedance Z (Ω)=estimated impedance voltage VZ (V) is performed.

The estimated open voltage calculating unit 14 receives the measured voltage V (V) corresponding to the voltage output from the voltage sensor connected to the secondary battery and the estimated impedance voltage VZ (V) and calculates an estimated open voltage VO (V) of the secondary battery by subtracting the estimated impedance voltage VZ (V) from the measured voltage V (V). The calculated estimated open voltage VO (V) is output to the SOCV calculating unit 17 to be described later.

The SOCV calculating unit 17 (a first estimated state of charge calculating unit) is a processing unit that receives the estimated open voltage VO (V) and the measured temperature T (°C) and that outputs SOCV (%) (the estimated state of charge of the secondary battery based on the estimated open voltage which is also referred to as a first estimated state of charge) to the SOC calculating unit 20 to be described later on the basis of these two pieces of information. In other words, it is a processing unit that calculates the estimated state of charge based on the voltage.

The SOCV calculating unit 17 includes data tables in which the measured temperatures T (°C) and SOCV (%) corresponding to the estimated open voltage VO (V) are recorded. Specifically, a data table is provided for every predetermined temperature (every 1°C such as 20°C, 21°C, and 22°C) and the values of the SOCV (%) for every predetermined estimated open voltage VO (V) (every 0.1 V such as 5.0 V, 5.1 V, and 5.2 V) are recorded on each data table.

Similarly to the processes in the estimated impedance table storage unit 12, when the measured temperature T (°C) is different from the temperatures prepared in the data tables, that is, when the temperature nearest to the measured temperature T (°C) in the data tables are T1 and T2 (T1 (°C)< T (°C)< T2 (°C)), the SOCV calculating unit 17 selects the data table prepared for T2 (°C) if (ΔT/2)<ΔT1 is established where T2-T1=ΔT and T-T1=ΔT1, and selects the data table prepared for T1 if ΔT1(ΔT/2) is established.

The SOCV calculating unit 17 selects the data table corresponding to the measured temperature T (°C) as described above, and then selects the SOCV (%) corresponding to the estimated open voltage VO (V) input from the estimated open voltage calculating unit 14. Aft this time, when estimated open voltage VO (V) is different from the value of the estimated open voltage prepared in the data table, that is, when the estimated open voltages nearest to the input estimated open voltage VO (V) among the predetermined estimated open voltages prepared in the selected data table are VO1 and VO2 (VO1 (V)<VO (V)<VO2 (V)), the estimated opening voltage corresponding to VO2 (V) is selected if (ΔVO/2)≤ΔVO1 is established where VO2-VO1=ΔVO and VO-VO1=ΔVO1, and the estimated open voltage corresponding to VO1 is selected if ΔVO1<(ΔVO/2) is established. For example, when the estimated open voltage input from the estimated open voltage calculating unit 14 at a certain measured temperature is 5.04 V and two estimated open voltages of 5.0 V and 5.1 V nearest to the estimated open voltage are prepared in the data table corresponding to the measured temperature, the SOCV (%) corresponding to the estimated open voltage of 5.0 V is selected and is output to the SOC calculating unit 20. This is because it is possible to calculate the state of charge with a smaller error by using the SOCV (%) corresponding to the estimated open voltage closer to the estimated open voltage VO (V) output from the estimated open voltage calculating unit 14.

The SOC upper and lower limit calculating unit 18 (a second estimated state of charge calculating unit) is a processing unit that performs the following calculations in the period of a predetermined calculation cycle L (s) in accordance with a cycle signal generated for each predetermined calculation cycle L (s) (for example, 1 seconds) by the calculation cycle storage unit 19 using the measured current I (A) corresponding to the current output from the current sensor disposed in the corresponding arm, the upper limit ΔIH (A) and the lower limit ΔIL (A) of the error stored in the error determining unit 15, and the battery capacity Ah (Ah) stored in the battery capacity presumption unit 16, that calculates the upper limit SOC-H (%) (hereinafter, also referred to as SOCH and also referred to as a second estimated state of charge) and the lower limit SOC-L (%) (hereinafter, also referred to as SOCL and also referred to as a third estimated state of charge) of the estimated state of charge of the secondary battery and the SOCI (%) (also referred to as a fourth estimated state of charge), and that outputs the calculated values to the SOC calculating unit 20. It can also be said to be a processing unit that calculates the estimated state of charge based on the current.

The calculation expressions are as follows.

$$SOCI=SOCInit+100\times\int(I)dt/(3600\times Ah)$$

$$SOCH=SOCInit+100\times\int(I+\Delta IH)dt/(3600\times Ah)$$

$$=SOCI+100\times\int(\Delta IH)dt/(3600\times Ah)$$

$$SOCL=SOCInit+100\times\int\int(I+\Delta IL)dt/(3600\times Ah)$$

$$=SOCI+100\times\int(\Delta IL)dt/(3600\times Ah)$$

Here, the upper limit $\Delta IH$ (A) ($\Delta IH>0$) and the lower limit $\Delta IL$ (A) ($\Delta UL<0$) of the error are the upper limit and the lower limit of the error range of the sensitivity of the current sensor and are fixed values preliminarily set for the current sensor used. These two values are stored in a memory (for example, a nonvolatile memory) of the error determining unit.

The battery capacity AH (Ah) is the overall battery capacity preliminarily set for the secondary battery and may be a fixed value. In this case, the fixed value can be stored in a memory (for example, a nonvolatile memory) in the battery capacity presumption unit.

SOCInit (%) is an initial value for each calculation cycle L (s) and is the output value from the SOC calculating unit 20 to be described later, that is, the optical value transmitted from the SOC calculating unit 20, at the time other than the time of starting up the system to be described later.

The integrated values of the calculations are values integrated in the calculation cycle L (s).

Here, the battery capacity stored in the battery capacity presumption unit 16 is set to a fixed value. However, since the battery capacity can vary depending on the temperature of the battery vessel and the current value output from the secondary battery, the battery capacity may be set to a variable having these two values as parameters so as to calculate the state of charge with a smaller error. In this case, the data is previously measured to prepare a data table and the battery capacity is determined from the data table.

In this case, the battery capacity presumption unit 16 receives the measured temperature T (°C) and the measured current I (A) and transmits the battery capacity Ah (Ah) corresponding to the measured temperature T (°C) and the measured current I (A) to the SOC upper and lower limit calculating unit 18 using the data table.

Specifically, the battery capacity presumption unit includes data tables having recorded thereon the battery capacity Ah (Ah) corresponding to the measured temperature T (°C) and the measured current I (A). A data table is provided for every predetermined temperature (every 1°C-such as 20°C, 2.1°C, and 22°C) and the values of the battery capacity for every predetermined measured value I (A) (every 0.1 A such as 1.0 A, 1.1 A, and 1.2 A) are recorded on each data table. Similarly to the processes in the estimated impedance table storage unit 12, when the measured temperature T (°C) is different from the temperatures prepared in the data tables, that is, when the temperature nearest to the measured temperature T (°C) in the data tables are T1 and T2 (T1 (°C)< T (°C)< T2 (°C)), the battery capacity presumption unit 16 selects the data table prepared for T2 (°C) if $(\Delta T/2)\leq\Delta T1$ is established where $T2-T1=\Delta T$ and $T-T1=\Delta T1$, and selects the data table prepared for T1 if $\Delta T1<(\Delta T/2)$ is established.

The battery capacity presumption unit 16 selects the data table corresponding to the measured temperature T (°C) as described above, and then selects the battery capacity corresponding to the measured current I (A). At this time, when the measured current I (A) is different from the values of predetermined measured currents prepared in the data table, that is, when the measured currents nearest to the measured current I (A) among the predetermined measured currents prepared in the selected data table are I1 and I2 (I1 (A)<I (A)<I2 (A)), the battery capacity corresponding to I2 (A) if $(\Delta I/2)\leq\Delta I1$ is established where $I2-I1=\Delta I$ and $I-I1=\Delta I1$, and the battery capacity corresponding to I1 if $\Delta I1<(\Delta I/2)$ is established. For example, when the measured current value at a certain measured temperature is 1.05 A and two measured current values of 1.0 A and 1.1 A nearest to the measured current value are prepared in the data table corresponding to the measured temperature, the battery capacity corresponding to the measured current value of 1.1 A is selected and is output as the battery capacity Ah (Ah to the SOC upper and lower limit calculating unit 18. This is because it is possible to calculate the state of charge with a smaller error by using the value of the battery capacity corresponding to the current value closer to the measured current value (A).

The SOC calculating unit 20 (the state of charge determining unit) receives SOC-H (%), SOC-L (%), SOCI (%), and SOCV (%) from the SOC upper and lower limit calculating unit 18 and the SOCV calculating unit 17. The SOC calculating unit 20 is a processing unit that selects one of three values of SOC-H (%), SOC-L (%), and SOCV (%) as the optimal value nearest to the actual state of charge.

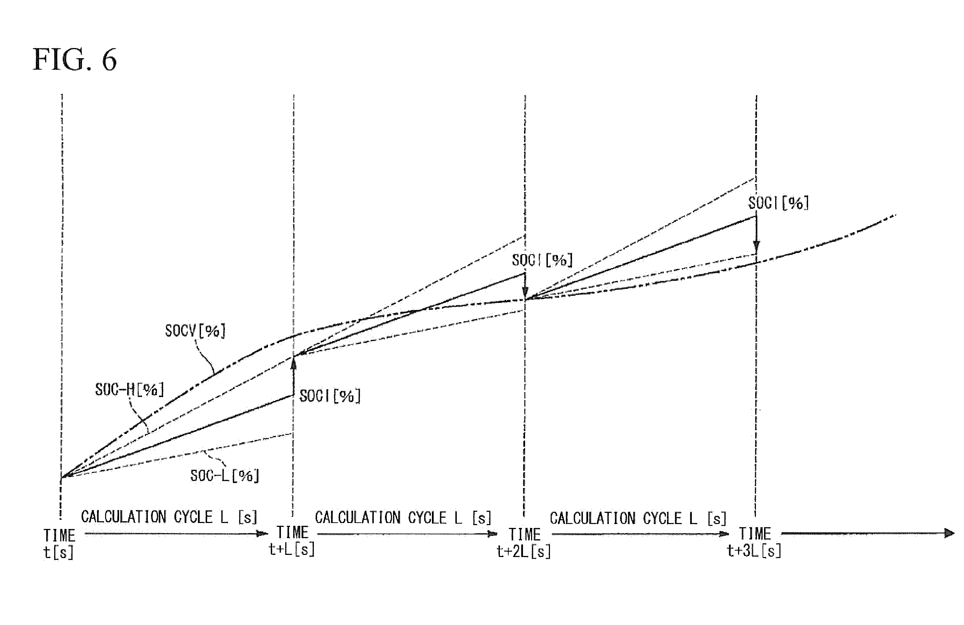

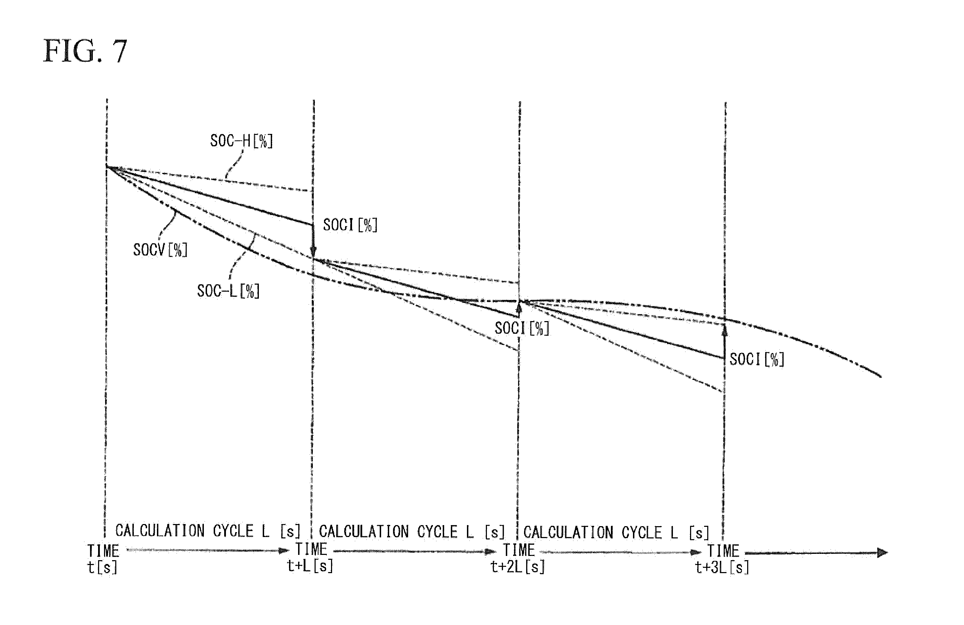

The selected optimal value is transmitted as the charging rate SOC (%) of the secondary battery for each calculation cycle L (s) from the SOC calculating unit 20 to the higher control unit 102 controlling the charging and discharging of the secondary battery using the state of charge. The SOC calculating unit 20 transmits SOCI (%) as the charging rate SOC (%) to the higher control unit 102 or the like in the period of the calculation cycle L (s). The mechanism for selecting the optimal value will be described later with reference to FIGS. 6 and 7.

The higher control unit 102 transmits the received values of the state of charge SOC (%) of the secondary batteries, for example, to the display unit 103 shown in FIG. 1, and the display unit 103 displays the state of charge by the use of light, sound, or the like to cause a user of the battery system 100 to recognize the state of charge.

Just before a start switch (not shown) of the battery system 100 included in the higher control unit 102 is turned off and the supply of power to the units such as the SOC calculating unit 1 in the battery system from the secondary batteries is stopped, the higher control unit 102 stores the previous state of charge SOC (%) transmitted from the SOC calculating unit 20 in the nonvolatile memory built therein. Just after the start switch is turned on to start the supply of power to the units such as the SOC calculating unit 20 in the battery system from the secondary batteries, the higher control unit 102 transmits the state of charge SOC (%) stored in the nonvolatile memory as SOCInit (%) to the SOC upper and lower limit calculating unit 18 and the estimated impedance table storage unit 12. Accordingly, even when the start switch is turned on but the SOC calculating unit 20 does not transmit the optimal value, SOCInit (%) can be given and thus the calculations establishing the above-mentioned expressions can be performed.

When the impedance voltage caused from the influence of the charging and discharging current in the period in which the start switch is turned off is sufficiently smaller than the measured voltage and can be neglected, the SOCV may be used as the SOCInit (%).

As described above, the estimated impedance table storage unit 12, the SOCV calculating unit 17, and the battery capacity presumption unit 16 select and output the output values, that is, the estimated impedance Z ($\Omega$), the SOCV (%), and the battery capacity Ah (Ah), using the data tables corresponding to two parameters input thereto. These two parameters include the measured temperature T (°C) and the state of charge SOC (%) for the estimated impedance table storage unit 12, the measured temperature T (°C) and the estimated open voltage VO (V) for the SOCV calculating unit 17, and the measured temperature T (°C) and the measured current I (A) for the battery capacity presumption unit 16. The data table corresponding to the measured temperature T (°C) which is one of the two parameters is first selected and then the output values are selected using the other parameter. Here, when the value corresponding to the other parameter is not prepared in the data table, the nearest value among the prepared values is considered as the value of the other parameter and the value corresponding thereto is output as the output value.

However, in order to further reduce the error of the state of charge SOC (%), the output value may be determined using the linear ratio of P with respect to the nearest value (referred to as "nearest value 1") smaller than the value of the other parameter among the prepared values and the nearest value (referred to as "nearest value 2") larger than the value of the other parameter.

In this case, the actual output value is output value=output value 1+(output value 2-output value 1)×(P-nearest value 1)/(nearest value 2-nearest value 1), where output value 1 represents the output value corresponding to nearest value 1 prepared in the data tables and output value 2 represents the output value corresponding to nearest value 2.

For example, the estimated impedance table storage unit 12 includes a data table for every predetermined temperature (every 1°C such as 20°C, 21°C, and 22°C) as described above and the values of the estimated impedance for every predetermined state of charge (every 5% such as 40%, 45%, and 50%) are stored on each data table.

Here, when the state of charge SOC (%) input from the SOC calculating unit 20 at a certain measured temperature is 43%, two state of charge of 40% and 45% nearest to the state of charge SOC (%) are prepared in the data table corresponding to the measured temperature, the estimated impedance corresponding to the state of charge of 40% is prepared as 0.001 $\Omega$ in the data table, and the estimated impedance corresponding to the state of charge 45% is prepared as 0.002 $\Omega$, the value of the estimated impedance Z ($\Omega$) transmitted from the estimated impedance table storage unit 12 is 0.001($\Omega$)+(0.002($\Omega$)-0.001($\Omega$))×(43(%)-40(%))/(45(%)-40(%))=0.0016($\Omega$).

The SOCV calculating unit 17 and the battery capacity presumption unit 16 can perform the processes in the same way.

FIG. 6 is a first diagram schematically illustrating the processes of the SOC calculating unit 1.

As shown in the drawing, the SOC calculating unit 1 calculates SOCV (%), SOC-H (%), and SOC-L (%) from time t (s) to time t+L (s). The SOC calculating unit 1 calculates the estimated state of charge SOCI (%) of the secondary batteries through the integration of the measured current using the state of charge at time t (s) as the initial value SOCInit (%) from time t (s) to time t+L (s). Since SOCV (%) at time t+L (s) is greater than the range of SOC-L (%) and SOC-H (%), the SOC calculating unit 1 determines SOC-H (%) as the present state of charge of the secondary battery. That is, the value of the estimated state of charge SOCI (%) of the secondary battery calculated from the measured current is corrected up to the value of the estimated state of charge, SOC-H (%) calculated using the upper limit of the error ofthe measured current and the estimated state of charge is then output.

The SOC calculating unit 1 calculates SOCV (%), SOC-H (%), and SOC-L (%) from time t+L (s) to time t+2L (s). The SOC calculating unit 1 calculates the estimated state of charge SOCI (%) of the secondary batteries through the integration of the measured current using the state of charge at time t+L (s) as the initial value SOCInit (%) from time t+L (s) to time t+2L (s). Since SOCV (%) at time t+2L (s) is in the range of SOC-L (%) and SOC-H (%), the SOC calculating unit 1 determines SOCV (%) as the present state of charge of the secondary battery. That is, the value of SOCV is determined to be reliable, the value of the estimated state of charge SOCI (%) of the secondary battery calculated from the measured current is switched to the estimated state of charge SOCV calculated on the basis of the estimated open voltage and the estimated state of charge is then output.

The SOC calculating unit 1 calculates SOCV (%), SOC-H (%), and SOC-L (%) from time t+2L (s) to time t+3L (s). The SOC calculating unit 1 calculates the estimated state of charge SOCI (%) of the secondary batteries through the integration of the measured current using the state of charge at time t+2L (s) as the initial value SOCInit (%) from time t+2L (s) to time t+3L (s). Since SOCV (%) at time t+3L (s) is less than the range of SOC-L (%) and SOC-H (%), the SOC calculating unit 1 determines SOC-L (%) as the present state of charge ofthe secondary battery. That is, the value of the estimated state of charge SOCI (%) of the secondary battery calculated from the measured current is corrected down to the value of the estimated state of charge SOC-L (%) calculated using the lower limit of the error of the measured current and the estimated state of charge is then output.

FIG. 7 is a second diagram schematically illustrating the processes of the SOC calculating unit 1. FIG. 6 schematically illustrates the processes when the state of charge of the secondary battery ascends, but FIG. 7 schematically illustrates the processes when the state of charge of the secondary battery descends. In FIG. 7, similarly to FIG. 6, the value of SOCI (%) is switched to SOCV (%) or SOC-H (%) or SOC-L (%) for every calculation cycle and the switched value is determined as the present state of charge. At this time, similarly, SOCV (%) is determined to be the present state of charge when SOCV (%) is in the range of SOC-H (%) and SOC-L (%). Also, SOC-H (%) is determined to be the present state of charge when SOCV (%) is greater than the range of SOC-H (%) and SOC-L (%). Also, SOC-L (%) is determined to be the present state of charge when SOCV (%) is less than the range of SOC-H (%) and SOC-L (%)

According to the above-mentioned processes, when it can be considered that the value of SOCV (%) is a value in a reliable range (the range of the estimated state of charge of from SOC-L (%) to SOC-H (%) reflecting the error of the measured current), the value of SOCV (%) is determined to be the present estimated state of charge SOC (%) for every calculation cycle. Since the reliability of SOCV (%) is generally higher than the reliability of SOCI (%), the value of SOCV (%) is determined to be the present estimated state of charge.

When it can be considered that the value of SOCV (%) is a value in a non-reliable range (other than the range of the estimated state of charge of from SOC-L (%) to SOC-H (%) reflecting the error of the measured current), the value of the upper limit SOC-H (%) or the lower limit SOC-L (%) of the error of SOCI (%) closer to the value of SOCV (%) is determined to be the present estimated state of charge SOC (%) for every calculation cycle.

Accordingly, a most likely value as the present state of charge can be obtained from the SOCV (%), which is calculated on the basis of the estimated open voltage VO (V), and the relationship between the estimated state of charge SOC-H (%) and SOC-L (%) counting on errors of the measured current I (A) even in a case where the internal resistance increases with the degradation of the secondary battery and the estimated value of the open voltage of the secondary battery is not reliable. Accordingly, it is possible to suppress the mixing of the previous cumulative error into the calculated value of the state of charge and thus to improve the accuracy of the calculation result of the state of charge.

As described above, in the battery system 100 according to this embodiment, the degradation determination of the respective secondary batteries can be carried out with a simple configuration in which the charging-discharging power efficiency is compared with the threshold value set for each present amount of charge (that is, each state of charge) accumulated in the corresponding secondary battery at the time point at which the discharge amount of charge and the charged amount of charge are equal to each other. By employing the above-mentioned configuration as the configuration of the SOC calculating unit 1, it is possible to more accurately perform the degradation determination.

Second Embodiment

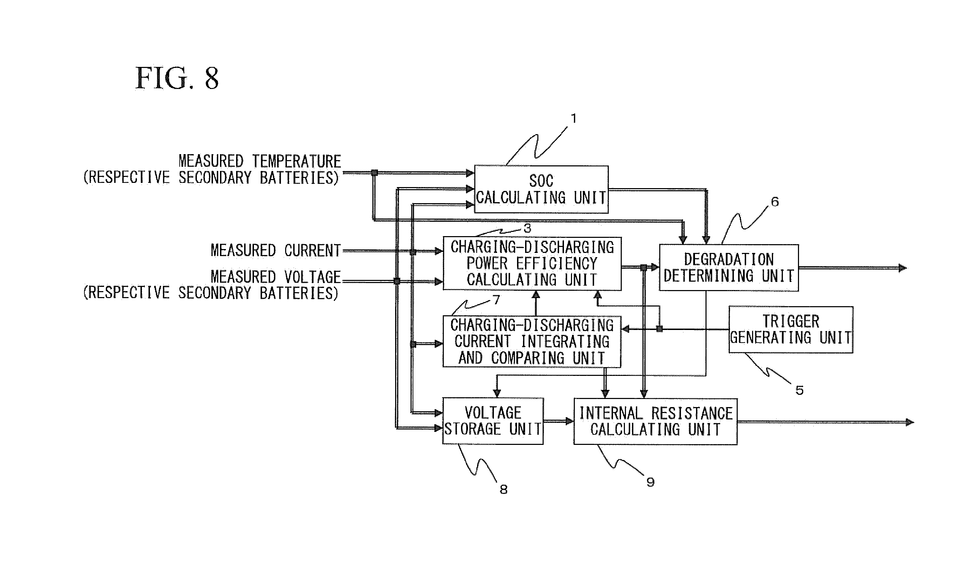

Hereinafter, a battery system according to a second embodiment of the invention will be described with reference to the accompanying drawings. This battery system has basically the same configuration as the battery system 100 according to the first embodiment, but is different from the battery system according to the first embodiment, in that a partial configuration of the BMS is replaced with the configuration shown in FIG. 8 instead of the configuration shown in FIG. 2. The elements referenced by the same reference signs are the same as in the first embodiment and thus will not be described in detail herel.

By employing the configuration shown in FIG 8, unlike the battery system according to the first embodiment, it is possible to calculate and transmit the internal resistance values of the respective secondary batteries to the higher control unit 102, in addition to the degradation determination of the respective secondary batteries.

In FIG. 8, the BMU includes a degradation determining unit 6 in which a new function is added to the degradation determining unit 4 shown in FIG. 2, a charging-discharging current integrating and comparing unit 7 in which a new function is added to the charging-discharging current integrating and comparing unit 2 shown in FIG. 2, and a voltage storage unit 8 and an internal resistance calculating unit 9 which are newly added to the configuration shown in FIG. 2, in addition to an SOC calculating unit 1, a charging-discharging power efficiency calculating unit 3, and a trigger generating unit 5 which perform the same operations as shown in FIG. 2. Hereinafter, the functions other than the newly-added functions are the same as those in the first embodiment and will not be described here, and the newly-added functions will be described.

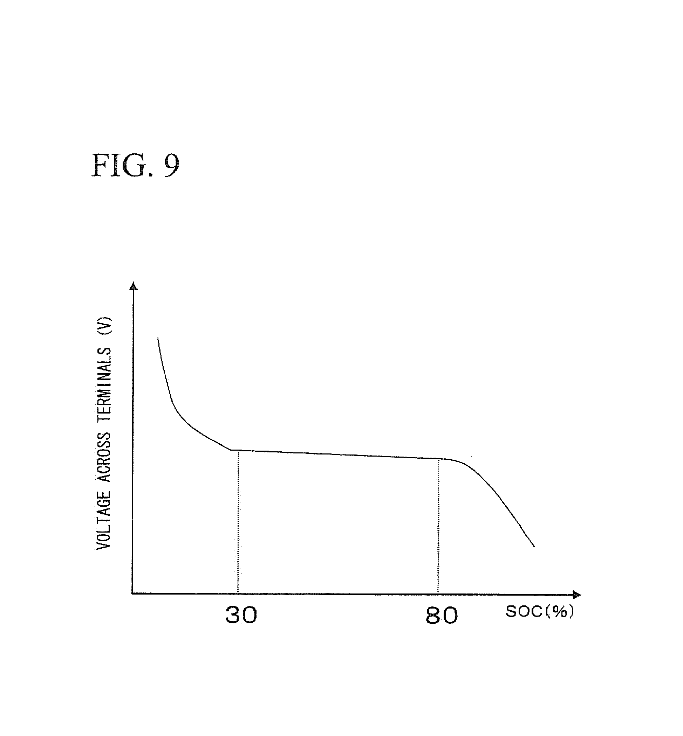

First, the mechanism capable of calculating an internal resistance value will be described below. As shown in FIG. 9, in a charging-discharging curve of a secondary battery, a phenomenon in which the voltage across terminals substantially converges on a constant value in a constant range of state of charge SOC is observed. Here, the state of charge SOC at the lowest end in the substantially constant range is defined as a minimum state of charge SOC1 and the state of charge SOC at the highest end in the substantially constant range is defined as a maximum state of charge SOC2. In FIG. 9, SOC1=30% and SOC2=80% are observed. Depending on the combination of a positive electrode material, a negative electrode material, and an electrolyte and the composition thereof, the substantially constant voltage may be slightly tilted or the values of SOC1 and SOC2 may vary. However, when the charging and discharging operations are repeated for a short time in a large-capacity secondary battery, the voltage across terminals between SOC1 and SOC2 can be considered to be substantially constant.

In order to stably perform the operations of a battery system in consideration of the characteristics of the secondary battery shown in FIG. 9, it is preferable that the battery system be activated in the range of the state of charge in which the voltage is substantially constant, that is, in the range of from SOC1 to SOC2.

This embodiment is on the premise that a battery system is activated in the range of from SOC1 to SOC2 from this point of view. Accordingly, the value of the internal voltage is considered to be substantially constant and to be a fixed value.

As described above, paying attention to the secondary battery Ca in FIG. 4, the value of the measured voltage corresponding to the voltage across terminals at the time of discharging and being measured by the voltage sensor Va is defined as $V_{dis}$, the value of the measured voltage corresponding to the voltage across terminals at the time of charging and being measured by the voltage sensor Va is defined as $V_{cha}$, the value of the measured current corresponding to the discharging current of the secondary battery Ca is defined as $I_{dis}$, the value of the measured current corresponding to the charging current of the secondary battery Ca is defined as $I_{cha}$, and the internal resistance Ra is considered to be a fixed value because the degradation determination is performed within a period of time in which the internal resistance does not vary. As described above, VA is considered to be a fixed value.

Here, the charging-discharging power efficiency E is expressed by $E=\{\int(I_{dis}\times V_{dis})dt\}/\{\int(I_{cha}\times V_{cha})dt\}$ as described above, where $V_{cha}=Va+(Ra\times I_{cha})$ and $V_{dis}=Va-(Ra\times I_{dis})$. Accordingly, when the numerator in the expression of the charging-discharging power efficiency E is defined as E1 and the denominator is defined as E2, the following expressions are obtained.

$$E1=\int(I_{dis}\times V_{dis})dt$$

$$=\int(VA\times I_{dis})dt-\int(Ra\times(I_{dis})^2)dt$$

$$=VA\times\int(I_{dis})dt-Ra\times\int(I_{dis})^2dt$$

$$E2=\int(I_{cha}\times V_{cha})dt$$

$$=\int(VA\int I_{cha})dt+\int(Ra\times(I_{cha})^2)\ dt$$

$$=VA\times\int(I_{cha})dt+Ra\times\int(I_{cha})^2dt$$

Similarly to the first embodiment, the degradation of a secondary battery is determined when the charging current integrated value and the discharging current integrated value are equal (or substantially equal) to each other. Accordingly, when $\int(I_{cha})dt=\int(I_{dis})dt=\alpha$ is established, the following expressions are obtained.

$$E1=VA\times\alpha-Ra\times\int(I_{dis})^2dt$$

$$E2=VA\times\alpha+Ra\times\int(I_{cha})^2dt$$

Therefore, since the charging-discharging power efficiency calculating unit 3 calculates the value of E which is a fixed value, the value of the internal resistance Ra can be calculated by obtaining the values of VA, $\alpha$, $\int(I_{dis})^2dt$, and $\int(I_{cha})^2dt$, all of which are fixed values. That is, the value of the internal resistance can be calculated as

$$Ra=\{Va\times(1-E)\}/\{(\int(I_{dis})^2dt+E\times\int(I_{cha})^2dt)\}.$$

Accordingly, in the configuration shown in FIG. 8, the new functions of calculating the values of VA, $\alpha$, $\int(I_{dis})^2dt$, and $\int(I_{cha})^2dt$ are added to the configuration shown in FIG. 2.

The configuration shown in FIG. 8 will be described below in detail.

First, the degradation determining unit 6 has a new function of outputting a reset signal in synchronization with the output of a normal signal or an abnormal signal in addition to the function of the degradation determining unit 4.

The voltage storage unit 8 receives the value of the measured current and the value of the measured voltage and stores and retains the value of the measured voltage when the measured current is 0 A. This stored voltage value is referred to as a retained voltage value. The voltage storage unit 8 outputs the retained voltage value to the internal resistance calculating unit 9 to be described later.

Here, when the measured current is 0 A, the voltage based on the internal resistance is not caused and thus the value of the internal voltage corresponds to the retained voltage value. That is, the retained voltage value is the value of VA.

The voltage storage unit 8 deletes the retained voltage value with the input of the reset signal and then stores and retains the value of the measured voltage when the measurement current is 0 A again.

The charging-discharging current integrating and comparing unit 7 receives the measured current corresponding to the current measured by the current sensor, separates the measured current into two types of the charging current and the discharging current, integrates the two types of current, and compares the charging current integrated value with the discharging current integrated value to determine whether both values are equal to each other, when the trigger signal output from the trigger generating unit 5 is input. In the integration, $\int(I_{cha})^2dt$ and $\int(I_{dis})^2dt$ are calculated at the same time as calculating $\int(I_{cha})dt$ and $\int(I_{dis})dt$.

When the values of $\int(I_{cha})dt$ and $\int(I_{dis})dt$ are equal to each other (the value of $\alpha$), a matching signal is output to the charging-discharging power efficiency calculating unit 3.

The values of $\alpha$, $\int(I_{cha})^2dt$, and $\int(I_{dis})^2dt$ are output to the internal resistance calculating unit 9 to be described later in synchronization with the output of the matching signal.

The internal resistance calculating unit 9 calculates the value of the internal resistance when the retained voltage value from the voltage storage unit 8, the values of $\alpha$, $\int(I_{cha})^2dt$, and $\int f(I_{dis})^2\,dt$ from the charging-discharging current integrating and comparing unit 7, and the charging-discharging power efficiency E from the charging-discharging power efficiency calculating unit 3 are input.

Paying attention to the secondary battery Ca, the value of the internal resistance thereof is calculated as $Ra=\{Va\times(1-E)\}/\{(\int(I_{dis})^2dt+E\times\int(I_{cha})^2dt)\}$. The calculated value of the internal resistance is transmitted to the higher control unit 102. A user can display the values of the internal resistance on the display unit 103 by appropriately operating the higher control unit 102.

Therefore, since the higher control unit 102 in the battery system according to this embodiment can grasp which secondary battery of the secondary batteries Ca to Ch constituting the battery system is abnormal or normal and can also grasp the values of the internal resistance, it is possible to display information of, for example, only abnormal secondary batteries on the display unit 103 and to draw a user's attention so as to, for example, urge the user to repair the battery system.

The invention is not limited to the above-mentioned embodiments, but may be modified in various forms without departing from the concept of the invention. For example, in the first and second embodiments, the degradation determination of the secondary batteries is performed in the BMU. However, the corresponding configuration may be disposed in the higher control unit 102 and the degradation determination may be performed in the higher control unit 102. The degradation determination is not limited to the case where the charged amount and the discharged amount o of a secondary battery are completely equal to each other, but the degradation determination may be performed when both amounts are substantially equal to each other.

All the data tables above described may be constructed in a nonvolatile memory.

It has been stated above that the battery system includes plural arms, but the battery system may include only one arm or may include only one secondary battery instead of the battery system.

Industrial Applicability

The invention relates to a battery system including: a secondary battery; a temperature sensor that measures the temperature of the secondary battery and outputs the measured temperature as temperature information, a current sensor that measures the current ofthe secondary battery and outputs the measured current as current information; a voltage sensor that measures the voltage of the secondary battery and outputs the measured voltage as voltage information; and a control unit that receives the temperature information, the current information, and the voltage information, wherein the control unit calculates the charging-discharging power efficiency of the secondary battery using the current information and the voltage information, calculates the state of charge of the secondary battery using the temperature information, the current information, and the voltage information, determines whether the amount of charge discharged from the secondary battery is substantially equal to the amount of charge charged in the secondary battery using the current information, and compares a threshold value set to correspond to the state of charge with the charging-discharging power efficiency to determine the degradation of the secondary battery when it is determined that both amounts of charge are equal to each other. According to the invention, it is possible to accurately determine the degradation state of plural secondary batteries with a simple configuration.

Reference Signs List

1: SOC CALCULATING UNIT
2: CHARGING-DISCHARGING CURRENT INTEGRATING AND COMPARING UNIT
3: CHARGING-DISCHARGING POWER EFFICIENCY CALCULATING UNIT
4: DEGRADATION DETERMINING UNIT
5: TRIGGER GENERATING UNIT
6: DEGRADATION DETERMINING UNIT
7: CHARGING-DISCHARGING CURRENT INTEGRATING AND COMPARING UNIT
8: VOLTAGE STORAGE UNIT
9: INTERNAL RESISTANCE CALCULATING UNIT
11: ESTIMATED IMPEDANCE MODEL UNIT
12: ESTIMATED IMPEDANCE TABLE STORAGE UNIT
13: ESTIMATED IMPEDANCE VOLTAGE CALCULATING UNIT
14: ESTIMATED OPEN VOLTAGE CALCULATING UNIT
15: ERROR DETERMINING UNIT
16: BATTERY CAPACITY PRESUMPTION UNIT
17: SOCV CALCULATING UNIT
18: SOC UPPER AND LOWER LIMIT CALCULATING UNIT
19: CALCULATION CYCLE STORAGE UNIT
20: SOC CALCULATING UNIT
100: BATTERY SYSTEM
101: BATTERY MODULE
102: HIGHER CONTROL UNIT
103: DISPLAY UNIT
104: ELECTRIC LOAD
105: BMS

**Claims**

**1.** A battery system comprising:

a secondary battery;

a temperature sensor that measures the temperature of the secondary battery and outputs the measured temperature as temperature information;

a current sensor that measures the current of the secondary battery and outputs the measured current as current information;

a voltage sensor that measures the voltage of the secondary battery and outputs the measured voltage as voltage information; and

a control unit that receives the temperature information, the current information, and the voltage information, wherein the control unit calculates a charging-discharging power efficiency of the secondary battery using the current information and the voltage information,

the control unit calculates a state of charge of the secondary battery using the temperature information, the current information, and the voltage information,

the control unit determines whether an amount of electric charge discharged from the secondary battery is substantially equal to an amount of electric charge charged in the secondary battery using the current information, and

the control unit determines the degradation of the secondary battery by comparing a threshold value and the charging-discharging power efficiency, the threshold value being set corresponding to the state of charge when the determination, in which the amount of electric charge discharged from the secondary battery is substantially equal to the amount of electric charge charged in the secondary battery, is obtained.

2. The battery system according to claim 1, further comprising a display unit,
wherein the control unit comprises:

an SOC calculating unit that calculates and outputs the state of charge of the secondary battery using the temperature information, the current information, and the voltage information;

a charging-discharging current integrating and comparing unit, which calculates the discharged amount of electric charge by integrating discharging information corresponding to the current information discharged from the secondary battery among the current information using the current information, calculates the charged amount of electric charge by integrating charging information corresponding to the current information charged in the secondary battery among the current information using the current information, and outputs a matching signal when the discharged amount and the charged amount are substantially matched with each other;

a charging-discharging power efficiency calculating unit, which calculates the charging-discharging power efficiency using the current information and the voltage information, and outputs the calculated charging-discharging power efficiency when the matching signal is input; and

a degradation determining unit, which receives the state of charge and the charging-discharging power efficiency, compares the charging-discharging power efficiency with the threshold value corresponding to the state of charge, and outputs the comparison result,

wherein the display unit displays the comparison result.

3. The battery system according to claim 2,
wherein the degradation determining unit holds a data table corresponding to the temperature information, and the degradation determining unit acquires the threshold value from the data table using the temperature information and the state of charge.

4. The battery system according to claim 3, wherein
the charging-discharging current integrating and comparing unit calculates and outputs: a first value obtained by integrating the discharging information; a second value obtained by integrating the square of the discharging information; a third value obtained by integrating the charging information; and a fourth value obtained by integrating the square of the charging information,
the control unit further comprises:

a voltage storage unit that stores and outputs internal voltage information corresponding to the voltage information when the current flowing in the secondary battery is substantially zero using the current information and the voltage information; and

an internal resistance calculating unit that receives the internal voltage information, the charging-discharging power efficiency, and the first to fourth values and calculates and outputs a value of internal resistance, and

the display unit displays the value of the internal resistance.

5. The battery system according to claim 3 or 4, wherein the SOC calculating unit comprises:

an SOCV calculating unit, which outputs a first estimated state of charge based on the voltages;
an SOC upper and lower limit calculating unit, which outputs a second estimated state of charge on the basis of the integration result of information corresponding to the current information and a current error upper limit in a predetermined cycle and the battery capacity of the secondary battery, outputs a third estimated state of charge on the basis of the integration result of the information corresponding to the current information and a current error lower limit in the predetermined cycle and the battery capacity of the secondary battery, and outputs a fourth estimated state of charge on the basis of the integration result of the information corresponding to the current information in the predetermined cycle and the battery capacity; and
an SOC calculating unit, which receives the first to fourth estimated state of charge, outputs the fourth estimated state of charge as the state of charge within a period of the predetermined cycle, outputs the first estimated state of charge as the state of charge when the first estimated state of charge has a value between the second estimated state of charge and the third estimated state of charge at the end point of the predetermined cycle, outputs the second estimated state of charge as the state of charge when the first estimated state of charge is equal to or greater than the second estimated state of charge, and outputs the third estimated state of charge as the state of charge when the first estimated state of charge is equal to or less than the third estimated state of charge.

# FIG. 1

# FIG. 2

MEASURED TEMPERATURE
(RESPECTIVE SECONDARY BATTERIES)

MEASURED CURRENT

MEASURED VOLTAGE
(RESPECTIVE SECONDARY BATTERIES)

SOC
CALCULATING UNIT — 1

CHARGING-DISCHARGING
POWER EFFICIENCY
CALCULATING UNIT — 3

DEGRADATION
DETERMINING UNIT — 4

CHARGING-DISCHARGING
CURRENT INTEGRATING
AND COMPARING UNIT — 2

TRIGGER
GENERATING
UNIT — 5

EP 2 624 358 A1

# FIG. 3

FIG. 4

# FIG. 5

EP 2 624 358 A1

# FIG. 6

SOCI[%]

SOCI[%]

SOCV[%]

SOCI[%]

SOC-H[%]

SOCI[%]

SOC-L[%]

| CALCULATION CYCLE L [s] | CALCULATION CYCLE L [s] | CALCULATION CYCLE L [s] |

TIME
t[s]

TIME
t+L[s]

TIME
t+2L[s]

TIME
t+3L[s]

EP 2 624 358 A1

FIG. 7

SOC-H[%]

SOCV[%]

SOC-L[%]

SOCI [%]

SOCI [%]

SOCI [%]

CALCULATION CYCLE L [s]   CALCULATION CYCLE L [s]   CALCULATION CYCLE L [s]

TIME
t[s]

TIME
t+L[s]

TIME
t+2L[s]

TIME
t+3L[s]

TIME

FIG. 8

MEASURED TEMPERATURE
(RESPECTIVE SECONDARY BATTERIES)

MEASURED CURRENT

MEASURED VOLTAGE
(RESPECTIVE SECONDARY BATTERIES)

1 — SOC CALCULATING UNIT

3 — CHARGING-DISCHARGING POWER EFFICIENCY CALCULATING UNIT

7 — CHARGING-DISCHARGING CURRENT INTEGRATING AND COMPARING UNIT

6 — DEGRADATION DETERMINING UNIT

5 — TRIGGER GENERATING UNIT

9 — INTERNAL RESISTANCE CALCULATING UNIT

8 — VOLTAGE STORAGE UNIT

25

FIG. 9

## INTERNATIONAL SEARCH REPORT

| International application No. |
|---|
| PCT/JP2011/071970 |

**A. CLASSIFICATION OF SUBJECT MATTER**
*H01M10/48(2006.01)i*

According to International Patent Classification (IPC) or to both national classification and IPC

**B. FIELDS SEARCHED**

Minimum documentation searched (classification system followed by classification symbols)
H01M10/48

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| P,X<br>P,A | JP 2010-271287 A  (Mitsubishi Heavy Industries,<br>Ltd.),<br>02 December 2010 (02.12.2010),<br>entire text; all drawings<br>(Family: none) | 1-3<br>4-5 |
| A | JP 62-089437 A  (Mitsubishi Electric Corp.),<br>23 April 1987 (23.04.1987),<br>entire text; all drawings<br>(Family: none) | 1-5 |

☐ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 02 December, 2011 (02.12.11) | 13 December, 2011 (13.12.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010214865 A
- JP 2010060408 A
- JP 2010093875 A
- JP 2004014403 A